# EUROPEAN PATENT SPECIFICATION

(11) **EP 2 696 651 B1**
(45) Date of publication and mention of the grant of the patent: **12.06.2019**
(21) Application number: 11846052.6
(22) Date of filing: 27.10.2011
(51) Int. Cl.: H04W 88/08, H04W 88/00, H03F 1/52, H03F 3/189, H03F 3/195, H03F 3/24

(54) **BASE STATION RADIO FREQUENCY SYSTEM AND PROTECTION METHOD OF RADIO FREQUENCY POWER AMPLIFIER**
BASISSTATIONS-FUNKFREQUENZSYSTEM UND SCHUTZVERFAHREN FÜR EINEN FUNKFREQUENZ-LEISTUNGSVERSTÄRKER
SYSTÈME DE RADIOFRÉQUENCE DE STATION DE BASE ET PROCÉDÉ DE PROTECTION D'UN AMPLIFICATEUR DE PUISSANCE À RADIOFRÉQUENCE

(30) Priority: 29.04.2011 CN 201110110874
(43) Date of publication of application: 12.02.2014
(73) Proprietor: ZTE Corporation, Shenzhen city, Guangdong 518057 (CN)
(72) Inventor: LIU, Jianli, Shenzhen, Guangdong 518057 (CN); CHEN, Huazhang, Shenzhen, Guangdong 518057 (CN); CUI, Xiaojun, Shenzhen, Guangdong 518057 (CN)
(74) Representative: Olsen, Svein Arne
(86) International application number: PCT/CN2011/081427
(87) International publication number: WO 2012/146012

(56) References cited:
- WO-A1-84/00258
- CN-A- 1 917 403
- CN-A- 102 170 653
- CN-Y- 201 294 489
- US-A- 4 660 003
- US-A1- 2003 045 251

## Description

### Technical Field

The present invention relates to the field of communication technologies, and more particularly, to a base station radio frequency system and a method for protecting a radio frequency power amplifier.

### Background of the Related Art

In a wireless communication system, a radio frequency power amplifier (power amplifier for short), which is one of core modules of the entire base station equipment system, amplifies baseband and downlink radio frequency signals output by a transceiver to a certain radio frequency power level for transmission via antennas, to achieve complete coverage, thereby ensuring unimpeded communication throughout a cell.

Data analysis shows that in the whole base station, power consumption of a power amplifier occupies about 60% of total power consumption, and the radio frequency power amplifier is the most energy-consuming component in the base station system and at the same time is a component with the harshest working environment (the largest power and highest temperature) in the whole base station. Therefore, ensuring good reliability of the radio frequency power amplifier so as not to damage it under various system environment conditions is a necessary condition of a mature product and also one of difficulties faced by numerous designers of power amplifiers.

In current wireless communication base station systems, in order to ensure linearity of power amplifiers and improve efficiency of the power amplifiers, the digital pre-distortion (DPD) technology is applied in the downlink.

Currently, for various reasons, a transceiver may output abnormal big signals with wide spectrum in power-up, initialization, operation, reset and power-down stages of a base station system. Such signals may cause a power amplifier to enter into an overload state instantly if input into the power amplifier, thus burn out a power amplifier device.

One of solutions to the problem that abnormal big signals with wide spectrum cause breakdown of power amplifiers is to avoid output of the abnormal big signals with wide spectrum using a complex method in a digital circuit. Because of various reasons of generating abnormal signals in the system and a wide range of locations where the abnormal signals are generated, it is impossible to completely avoid output of the abnormal big signals with wide spectrum.

Relevant technologies are also known from US 4660003 A (CLUNIAT CLAUDE [FR] ET AL) 21 April 1987 (1987-04-21).

### Content of the Invention

The present invention provides a base station radio frequency system and a method for protecting a radio frequency power amplifier so as to solve the existing problem that abnormal big signals with wide spectrum breakdown a power amplifier tube when input into the power amplifier.The features of the system and method according to the present invention are defined in the independent claims.

Using the base station radio frequency system and the method for protecting the radio frequency power amplifier described above, abnormal big signals with wide spectrum cannot enter the power amplifier, thereby achieving the object of protecting the power amplifier from being damaged.

### Brief Description of Drawings

FIG. 1 is a block diagram of a base station radio frequency system according to an embodiment of the present invention;
FIG. 2 is a structural schematic diagram of PD and PS circuits according to an embodiment of the present invention; and
FIG. 3 is a flowchart of a method for protecting a power amplifier according to a embodiment of the present invention.

### Preferred Embodiments of the Present Invention

In order to make objects, technical schemes and advantages of the present invention more clear and apparent, embodiments of the present invention will be described in detail in conjunction with the accompanying drawings. It should be noted that the embodiments of the present application and features in the embodiments can be combined randomly in the case of no conflict.

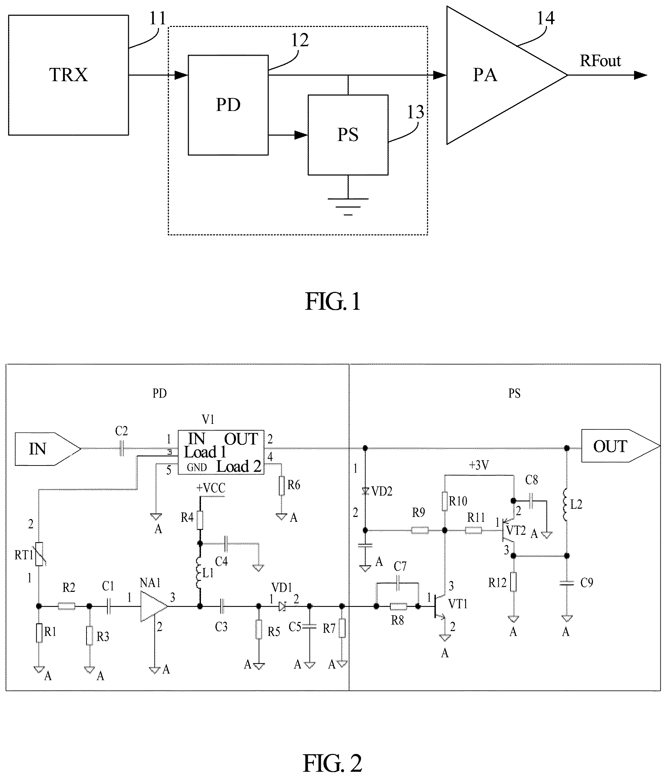

As shown in FIG. 1, a block diagram of a base station radio frequency system according to an embodiment of the present invention is provided. The system comprises a transceiver (TRX) 11, a protection detection circuit (PD) 12, a protection switch circuit (PS) 13 and a power amplifier (PA) 14. In the figure, RFout represents an output port of radio frequency signals. The protection detection circuit connected between the transceiver and the radio frequency power amplifier is configured to detect a signal output by the transceiver and send a turn-on control signal to the protection switch circuit when the signal is greater than a preset threshold. The protection switch circuit connected between the protection detection circuit and the radio frequency power amplifier is configured to receive the turn-on control signal sent by the protection detection circuit and control its grounded connection based on the turn-on control signal.

In the base station radio frequency system, a protection detection circuit and a protection switch circuit are added at an input port of the power amplifier. Normally, the protection switch circuit is ungrounded. When the transceiver outputs abnormal big signals with wide spectrum for various reasons, the protection detection circuit detects signal anomaly, controls turn-on of the protection switch circuit, makes short circuit of the abnormal big signals to ground, prevents the abnormal big signals from being input into the power amplifier, thereby avoiding breakdown of the power amplifier. When the signals are recovered to normal, the protection switch circuit is turned off again and the system is restored to work normally.

The base station radio frequency system described above has advantages of simple structure, small occupation area, low costs and high reliability, and it effectively protects the power amplifier and greatly reduces the possibility of damage of the power amplifier during system test, production, aging and external field application, improving the reliability of the system.

The PD and PS circuits in the base station radio frequency system shown in FIG. 1 can be implemented in a variety of ways, as shown in FIG. 2, a structural schematic diagram of the PD and PS circuits is provided.

The protection detection circuit comprises a coupler, an amplifier, a first diode, a first output, and a second output. The coupler is configured to sample the signal output by the transceiver, output the sampled signal to the amplifier, and output the signal output by the transceiver via the first output. The amplifier is configured to amplify the signal sampled by the coupler to a preset value. The first diode is configured to demodulate the signal amplified by the amplifier and output a direct current voltage to the protection switch circuit via the second output.

The protection switch circuit comprises a first transistor, a second transistor, a second diode and a third output. A positive terminal of the second transistor is connected to the first output and a negative terminal of the second transistor is connected to a ground terminal; a base of the first transistor is connected to the second output of the protection detection circuit; a base of the second transistor is connected to a collector of the first transistor, and the base of the second transistor is connected to the negative terminal of the second diode, and a collector of the second transistor is connected to the third output. The first transistor and the second transistor receive the direct current voltage output by the second output and are turned on when the direct current voltage is greater than a threshold voltage; and the second transistor is turned on to ground when both the first transistor and the second transistor are turned on.

Specifically, the coupler U1 samples the signal output by the transceiver, the amplifier NA1 amplifies the sampled signal to a desired level (the value of which may be preset as required), and the diode VD1 demodulates the amplified sample signal and outputs a direct current voltage. The diode VD2 is a radio frequency switch (which is turned on when a forward voltage is applied across the switch and is turned off when a reverse voltage is applied across the switch). When the signal output by the TRX is greater than a preset threshold, a direct current voltage output by VD1 turns on the transistors VT1 and VT2 (i.e. the direct current voltage output by VD1 is greater than threshold voltages of the two transistors such that the two transistors can be turned on), the forward voltage is applied across VD2 and the radio frequency switch is grounded, thereby protecting the power amplifier from burnout by big signals; when the signal output by the TRX is less than the preset threshold, the direct current voltage output by VD1 turns off the transistors VT1 and VT2, the radio frequency switch is ungrounded, and the signal is input into the power amplifier.

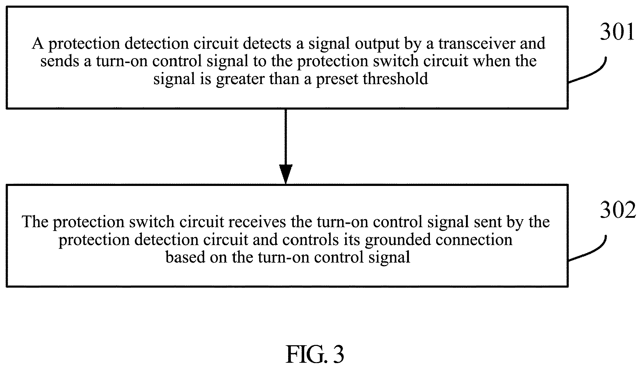

As shown in FIG. 3, a flowchart of a method for protecting a power amplifier according to an embodiment of the present invention is provided. The method is applied in the system shown in FIG. 1 and comprises the following steps.

In step 301, a protection detection circuit detects a signal output by a transceiver and sends a turn-on control signal to a protection switch circuit when the signal is greater than a preset threshold.

The preset threshold can be dynamically adjusted as required.

In step 302, the protection switch circuit receives the turn-on control signal sent by the protection detection circuit and controls its grounded connection based on the turn-on control signal.

Furthermore, the method can further comprise the protection detection circuit sending a turn-off control signal to the protection switch circuit when the signal is less than or equal to the preset threshold and the protection switch circuit receiving the turn-off control signal sent by the protection detection circuit and controls its ungrounded connection based the turn-off control signal.

Preferably, the protection detection circuit may comprise a coupler, an amplifier, a first diode, a first output, and a second output. Referring to FIG. 2 specifically, in the step of the protection detection circuit detecting the signal output by the transceiver and sending the turn-on control signal to the protection switch circuit when the signal is greater than the preset threshold, the coupler samples the signal output by the transceiver, outputs the sampled signal to the amplifier, and outputs the signal output by the transceiver via the first output; the amplifier amplifies the signal sampled by the coupler to a preset value; and the first diode demodulates the signal amplified by the amplifier and outputs a direct current voltage to the protection switch circuit via the second output.

Preferably, the protection switch circuit may comprise a first transistor, a second transistor, a second diode and a third output. A positive terminal of the second transistor is connected to the first output and a negative terminal of the second transistor is connected to a ground terminal, a base of the first transistor is connected to the second output of the protection detection circuit, a base of the second transistor is connected to a collector of the first transistor, and the base of the second transistor is connected to the negative terminal of the second diode, and a collector of the second transistor is connected to the third output.

In the step of the protection switch circuit receiving the turn-on control signal sent by the protection detection circuit and controlling its grounded connection based on the turn-on control signal, the first transistor and the second transistor receives the direct current voltage output by the second output and are turned on when the direct current voltage is greater than a threshold voltage, and the second transistor is grounded when both the first transistor and the second transistor are turned on.

The method can be applied in the base station radio frequency system, when the transceiver outputs abnormal big signals with wide spectrum for various reasons, the protection detection circuit detects signal anomaly, controls turn-on of the protection switch circuit, makes short circuit of the abnormal big signals to ground, prevents the abnormal big signals from being input into the power amplifier, thereby avoiding burnout of the power amplifier.

It may be understood by those skilled in the art that all or some of the steps in the described method can be implemented by related hardware instructed by programs which may be stored in computer readable storage mediums, such as read-only memory, disk or CD-ROM, etc. Alternatively, all or some of the steps in the embodiments described above may also be implemented using one or more integrated circuits. Accordingly, each module/unit in the embodiments described above may be implemented in a form of hardware, or software functional module. The present invention is not limited to combinations of hardware and software in any particular form.

The embodiments described above are merely used for describing the technical scheme of the present invention and is not intended to limit the present invention. The present invention is described in detail only with reference to preferred embodiments. Various modifications or equivalent substitutions to the present invention may be made by those skilled in the art without departing from the scope of the technical scheme of the present invention. Such modifications and substitutions should be covered in the scope of the appended claims of the present invention.

### Industrial Applicability

Using the present invention, abnormal big signals with wide spectrum cannot enter the power amplifier, thereby achieving the object of protecting the power amplifier from being damaged.

## Claims

1. A base station radio frequency system comprising a transceiver (11) and a radio frequency power amplifier (14) connected to each other, a protection detection circuit (12) and a protection switch circuit (13) comprising a grounded connection, wherein the protection detection circuit connected between the transceiver and the radio frequency power amplifier is configured to detect a signal output by the transceiver and send a turn-on control signal to the protection switch circuit when the signal is greater than a preset threshold; and
the protection switch circuit connected between the protection detection circuit and the radio frequency power amplifier is configured to receive the turn-on control signal sent by the protection detection circuit and control its grounded connection based on the turn-on control signal; wherein the protection detection circuit comprises a coupler (V1), an amplifier (NA1), a first diode (VD1), a first output, and a second output; wherein
the coupler is configured to sample the signal output by the transceiver, output the sampled signal to the amplifier, and output the signal output by the transceiver via the first output;
the amplifier is configured to amplify the signal sampled by the coupler to a preset value; and
the first diode is configured to demodulate the signal amplified by the amplifier and output a direct current voltage to the protection switch circuit via the second output;
the protection switch circuit comprises a first transistor (VT1), a second transistor (VT2), a second diode (VD2) and a third output, wherein an anode of the second diode is connected to the first output and a cathode of the second diode is configured to be connected to the grounded connection, a base of the first transistor is connected to the second output of the protection detection circuit, a base of the second transistor is connected to a collector of the first transistor, and the base of the second transistor is connected to the cathode of the second diode, and a collector of the second transistor is connected to the third output; and
the first transistor and the second transistor are configured to receive the direct current voltage output by the second output and to be turned on when the direct current voltage is greater than a threshold voltage; and the second transistor is configured to be grounded when both the first transistor and the second transistor are turned on.

2. The system according to claim 1, wherein
the protection detection circuit is further configured to send a turn-off control signal to the protection switch circuit when the signal is less than or equal to the preset threshold; and
the protection switch circuit is further configured to receive the turn-off control signal sent by the protection detection circuit and control its ungrounded connection based on the turn-off control signal.

3. A method for protecting a radio frequency power amplifier applied in a base radio frequency system comprising:
a protection detection circuit (12) detecting a signal output by a transceiver (11) and sending a turn-on control signal to a protection switch circuit (13) that comprises a grounded connection when the signal is greater than a preset threshold (301); and
the protection switch circuit receiving the turn-on control signal sent by the protection detection circuit and controlling its grounded connection based on the turn-on control signal (302); wherein
the protection detection circuit comprises a coupler (V1), an amplifier (NA1), a first diode (VD1), a first output, and a second output, wherein
the step of the protection detection circuit detecting the signal output by the transceiver and sending the turn-on control signal to the protection switch circuit when the signal is greater than the preset threshold comprises:
the coupler sampling the signal output by the transceiver, outputting the sampled signal to the amplifier, and outputting the signal output by the transceiver via the first output;
the amplifier amplifying the signal sampled by the coupler to a preset value; and
the first diode demodulating the signal amplified by the amplifier and outputting a direct current voltage to the protection switch circuit via the second output;
the protection switch circuit comprises a first transistor (VT1), a second transistor (VT2), a second diode (VD2) and a third output, wherein
an anode of the second diode is connected to the first output and a cathode of the second diode is configured to be connected to the grounded connection, a base of the first transistor is connected to the second output of the protection detection circuit, a base of the second transistor is connected to a collector of the first transistor, and the base of the second transistor is connected to the cathode of the second diode, and a collector of the second transistor is connected to the third output; and
in the step of the protection switch circuit receiving the turn-on control signal sent by the protection detection circuit and controlling its grounded connection based on the turn-on control signal:
the first transistor and the second transistor receives the direct current voltage output by the second output and are turned on when the direct current voltage is greater than a threshold voltage; and the second transistor is grounded when both the first transistor and the second transistor are turned on.

4. The method according to claim 3, further comprising:
the protection detection circuit sending a turn-off control signal to the protection switch circuit when the signal is less than or equal to the preset threshold; and
the protection switch circuit receiving the turn-off control signal sent by the protection detection circuit and controlling its ungrounded connection based on the turn-off control signal.

## Patentansprüche

1. Basisstationshochfrequenzsystem, Folgendes umfassend: einen Transceiver (11) und einen Hochfrequenzleistungsverstärker (14), die miteinander verbunden sind, eine Schutzerfassungsschaltung (12) und eine Schutzschalterschaltung (13), die eine geerdete Verbindung umfassen, wobei die Schutzerfassungsschaltung, die zwischen dem Transceiver und dem Hochfrequenzleistungsverstärker verbunden ist, konfiguriert ist, um ein durch den Transceiver ausgegebenes Signal zu erfassen und ein Einschaltsteuersignal an die Schutzschalterschaltung zu senden, wenn das Signal größer als ein voreingestellter Schwellenwert ist; und
die Schutzschalterschaltung, die zwischen der Schutzerfassungsschaltung und dem Hochfrequenzleistungsverstärker verbunden ist, konfiguriert ist, um das durch die Schutzerfassungsschaltung gesendete Einschaltsteuersignal zu empfangen und ihre geerdete Verbindung basierend auf dem Einschaltsteuersignal zu steuern;
wobei die Schutzerfassungsschaltung Folgendes umfasst: einen Koppler (V1), einen Verstärker (NA1), eine erste Diode (VD1), einen ersten Ausgang und einen zweiten Ausgang;
wobei der Koppler konfiguriert ist, um das durch den Transceiver ausgegebene Signal abzutasten, das abgetastete Signal an den Verstärker auszugeben und das durch den Transceiver ausgegebene Signal über den ersten Ausgang auszugeben;
der Verstärker konfiguriert ist, um das durch den Koppler abgetastete Signal auf einen voreingestellten Wert zu verstärken; und
die erste Diode konfiguriert ist, um das durch den Verstärker verstärkte Signal zu demodulieren und eine Gleichstromspannung über den zweiten Ausgang an die Schutzschalterschaltung auszugeben;
die Schutzschalterschaltung Folgendes umfasst: einen ersten Transistor (VT1), einen zweiten Transistor (VT2), eine zweite Diode (VD2) und einen dritten Ausgang, wobei eine Anode der zweiten Diode mit dem ersten Ausgang verbunden ist und eine Kathode der zweiten Diode konfiguriert ist, um mit der geerdeten Verbindung verbunden zu sein, eine Basis des ersten Transistors mit dem zweiten Ausgang der Schutzerfassungsschaltung verbunden ist, eine Basis des zweiten Transistors mit einem Kollektor des ersten Transistors verbunden ist und die Basis des zweiten Transistors mit der Kathode der zweiten Diode verbunden ist, und ein Kollektor des zweiten Transistors mit dem dritten Ausgang verbunden ist; und
der erste Transistor und der zweite Transistor konfiguriert sind, um die durch den zweiten Ausgang ausgegebene Gleichstromspannung zu empfangen und eingeschaltet zu werden, wenn die Gleichstromspannung größer als eine Schwellenspannung ist; und
der zweite Transistor konfiguriert ist, um geerdet zu sein, wenn sowohl der erste Transistor als auch der zweite Transistor eingeschaltet sind.

2. System nach Anspruch 1, wobei die Schutzerfassungsschaltung ferner konfiguriert ist, um ein Ausschaltsteuersignal an die Schutzschalterschaltung zu senden, wenn das Signal höchstens der voreingestellte Schwellenwert ist; und
die Schutzschalterschaltung ferner konfiguriert ist, um das durch die Schutzerfassungsschaltung gesendete Ausschaltsteuersignal zu empfangen und ihre ungeerdete Verbindung auf Grundlage des Ausschaltsteuersignals zu steuern.

3. Verfahren zum Schützen eines Hochfrequenzleistungsverstärkers, der in einem Basishochfrequenzsystem angewendet wird, Folgendes umfassend:
eine Schutzerfassungsschaltung (12), die ein durch einen Transceiver (11) ausgegebenes Signal erfasst und ein Einschaltsteuersignal an eine Schutzschalterschaltung (13) sendet, die eine geerdete Verbindung umfasst, wenn das Signal größer als ein voreingestellter Schwellenwert (301) ist; und
die Schutzschalterschaltung, die ein durch die Schutzerfassungsschaltung gesendetes Einschaltsteuersignal empfängt und ihre geerdete Verbindung auf Grundlage des Einschaltsteuersignals (302) steuert;
wobei die Schutzerfassungsschaltung Folgendes umfasst: einen Koppler (V1), einen Verstärker (NA1), eine erste Diode (VD1), einen ersten Ausgang und einen zweiten Ausgang, wobei der Schritt des Erfassens des durch den Transceiver ausgegebenen Signals durch die Schutzerfassungsschaltung und des Sendens des Einschaltsteuersignals an die Schutzschalterschaltung, wenn das Signal größer als die voreingestellte Schwelle ist, Folgendes umfasst:
Abtasten des durch den Transceiver ausgegebenen Signals, Ausgeben des abgetasteten Signals an den Verstärker und Ausgeben des durch den Transceiver ausgegebenen Signals über den ersten Ausgang durch den Koppler;
Verstärken des durch den Koppler abgetasteten Signals auf einen voreingestellten Wert durch den Verstärker; und
Demodulieren des durch den Verstärker verstärkten Signals und Ausgeben einer Gleichstromspannung über den zweiten Ausgang an die Schutzschalterschaltung durch die erste Diode;
die Schutzschalterschaltung Folgendes umfasst: einen ersten Transistor (VT1), einen zweiten Transistor (VT2), eine zweite Diode (VD2) und einen dritten Ausgang, wobei eine Anode der zweiten Diode mit dem ersten Ausgang verbunden ist und eine Kathode der zweiten Diode konfiguriert ist, um mit der geerdeten Verbindung verbunden zu sein,
eine Basis des ersten Transistors mit dem zweiten Ausgang der Schutzerfassungsschaltung verbunden ist, eine Basis des zweiten Transistors mit einem Kollektor des ersten Transistors verbunden ist und die Basis des zweiten Transistors mit der Kathode der zweiten Diode verbunden ist, und ein Kollektor des zweiten Transistors mit dem dritten Ausgang verbunden ist; und
in dem Schritt des Empfangens, durch die Schutzschalterschaltung, des durch die Schutzerfassungsschaltung gesendeten Einschaltsteuersignals und des Steuerns ihrer geerdeten Verbindung auf Grundlage des Einschaltsteuersignals
der erste Transistor und der zweite Transistor die durch den zweiten Ausgang ausgegebene Gleichstromspannung empfangen und eingeschaltet werden, wenn die Gleichstromspannung größer als eine Schwellenspannung ist; und
der zweite Transistor geerdet ist, wenn sowohl der erste Transistor als auch der zweite Transistor eingeschaltet sind.

4. Verfahren gemäß Anspruch 3, ferner Folgendes umfassend:
Senden eines Ausschaltsteuersignals an die Schutzschalterschaltung durch die Schutzerfassungsschaltung, wenn das Signal höchstens die voreingestellte Schwelle ist; und
Empfangen des durch die Schutzerfassungsschaltung gesendeten Ausschaltsteuersignals und Steuern ihrer ungeerdeten Verbindung auf Grundlage des Ausschaltsteuersignals durch die Schutzschalterschaltung.

## Revendications

1. Système radiofréquence de station de base comprenant un émetteur-récepteur (11) et un amplificateur de puissance radiofréquence (14) connectés l'un à l'autre, un circuit de détection de protection (12) et un circuit du commutateur de protection (13) comprenant une connexion à la masse, dans lequel le circuit de détection de protection connecté entre l'émetteur-récepteur et l'amplificateur de puissance radiofréquence est configuré pour détecter un signal émis par l'émetteur-récepteur et envoyer un signal de commande d'activation au circuit du commutateur de protection lorsque le signal est supérieur à un seuil prédéfini ; et
le circuit de commutateur de protection connecté entre le circuit de détection de protection et l'amplificateur de puissance radiofréquence est configuré pour recevoir le signal de commande d'activation envoyé par le circuit de détection de protection et pour commander sa connexion à la masse sur la base du signal de commande d'activation ;
dans lequel le circuit de détection de protection comprend un coupleur (V1), un amplificateur (NA1), une première diode (VD1), une sortie et une deuxième sortie ;
dans lequel le coupleur est configuré pour échantillonner le signal émis par l'émetteur-récepteur, émettre le signal échantillonné vers l'amplificateur et émettre le signal émis par l'émetteur-récepteur par l'intermédiaire de la première sortie ;
l'amplificateur est configuré pour amplifier le signal échantillonné par le coupleur à une valeur prédéfinie ; et
la première diode est configurée pour démoduler le signal amplifié par l'amplificateur et produire une tension en courant continu au circuit du commutateur de protection par l'intermédiaire de la deuxième sortie ;
le circuit du commutateur de protection comprend un premier transistor (VT1), un second transistor (VT2), une seconde diode (VD2) et une troisième sortie, une anode de la seconde diode étant connectée à la première sortie et une cathode de la seconde diode étant configurée pour être connectée à la connexion à la masse, une base du premier transistor étant connectée à la seconde sortie du circuit de détection de protection, une base du second transistor étant connectée à un collecteur du premier transistor, et la base du second transistor étant connectée à la cathode de la seconde diode, et un collecteur du second transistor étant connecté à la troisième sortie ; et
le premier transistor et le second transistor sont configurés pour recevoir la tension en courant continu délivrée par la deuxième sortie et pour être activés lorsque la tension en courant continu est supérieure à une tension de seuil ; et
le second transistor est configuré pour être mis à la masse lorsque le premier et le second transistor sont activés.

2. Système selon la revendication 1, dans lequel le circuit de détection de protection est configuré en outre pour envoyer un signal de commande de désactivation au circuit du commutateur de protection lorsque le signal est inférieur ou égal au seuil prédéfini ; et
le circuit du commutateur de protection est configuré en outre pour recevoir le signal de commande de désactivation envoyé par le circuit de détection de protection et pour commander sa connexion non mise à la masse sur la base du signal de commande de désactivation.

3. Procédé destiné à la protection d'un amplificateur de puissance radiofréquence appliqué dans un système de fréquence radio de base comprenant :
un circuit de détection de protection (12) détectant un signal émis par un émetteur-récepteur (11) et envoyant un signal de commande d'activation à un circuit du commutateur de protection (13) qui comprend une connexion à la masse lorsque le signal est supérieur à un seuil prédéfini (301) ; et
le circuit du commutateur de protection recevant le signal de commande d'activation envoyé par le circuit de détection de protection et commandant sa connexion à la masse sur la base du signal de commande d'activation (302) ;
dans lequel le circuit de détection de protection comprend un coupleur (V1), un amplificateur (NA1), une première diode (VD1), une sortie et une deuxième sortie ; dans lequel l'étape du circuit de détection de protection détectant le signal émis par l'émetteur-récepteur et envoyant le signal de commande d'activation du circuit du commutateur de protection lorsque le signal est supérieur au seuil prédéfini comprend :
le coupleur échantillonnant le signal émis par l'émetteur-récepteur, émettant le signal échantillonné vers l'amplificateur et émettant le signal émis par l'émetteur-récepteur par l'intermédiaire de la première sortie ;
l'amplificateur amplifiant le signal échantillonné par le coupleur à une valeur prédéfinie ; et
la première diode démodulant le signal amplifié par l'amplificateur et délivrant une tension en courant continu au circuit du commutateur de protection par l'intermédiaire de la deuxième sortie ;
le circuit du commutateur de protection comprend un premier transistor (VT1), un second transistor (VT2), une seconde diode (VD2) et une troisième sortie, une anode de la seconde diode étant connectée à la première sortie et une cathode de la seconde diode étant configurée pour être connectée à la connexion à la masse,
une base du premier transistor est connectée à la deuxième sortie du circuit de détection de protection, une base du second transistor est connectée à un collecteur du premier transistor, et la base du second transistor est connectée à la cathode de la seconde diode, et un collecteur du second transistor est connecté à la troisième sortie ; et
dans l'étape du circuit du commutateur de protection recevant le signal de commande d'activation envoyé par le circuit de détection de protection et commandant sa connexion à la masse sur la base du signal de commande d'activation :
le premier transistor et le second transistor reçoivent la tension en courant continu délivrée par la deuxième sortie et sont activés lorsque la tension en courant continu est supérieure à une tension de seuil ; et
le second transistor est mis à la masse lorsque le premier et le second transistors sont activés.

4. Procédé selon la revendication 3, comprenant en outre :
le circuit de détection de protection envoyant un signal de commande de désactivation au circuit du commutateur de protection lorsque le signal est inférieur ou égal au seuil prédéfini ; et
le circuit du commutateur de protection recevant le signal de commande d'activation envoyé par le circuit de détection de protection et commandant sa connexion à la masse sur la base du signal de commande de désactivation.
